# EUROPÄISCHE PATENTSCHRIFT

(11) **EP 4 045 935 B1**
(45) Veröffentlichungstag und Bekanntmachung des Hinweises auf die Patenterteilung: **05.11.2025**
(21) Anmeldenummer: 20771855.2
(22) Anmeldetag: 15.09.2020
(51) Int. Cl.: G01S 7/481, G01S 7/521, G01S 13/931, G01S 15/931, G01S 17/931, G01S 7/02

(54) **ELEKTRONISCHES SYSTEM MIT WÄRMEÜBERTRAGUNGSVORRICHTUNG**
ELECTRONIC SYSTEM WITH HEAT TRANSFER DEVICE
SYSTÈME ÉLECTRONIQUE AVEC DISPOSITIF DE TRANSFERT DE CHALEUR

(30) Priorität: 16.10.2019 DE 102019215957
(43) Veröffentlichungstag der Anmeldung: 24.08.2022
(73) Patentinhaber: Volkswagen Aktiengesellschaft, 38440 Wolfsburg (DE)
(72) Erfinder: BUCHOLSKI, Jan, 38104 Braunschweig (DE); EWALD, Stefan, 38547 Calberlah (DE)
(86) Internationale Anmeldenummer: PCT/EP2020/075704
(87) Internationale Veröffentlichungsnummer: WO 2021/073819

(56) Entgegenhaltungen:
- DE-A1- 102018 202 303
- US-A1- 2005 168 941

## Beschreibung

Die vorliegende Erfindung betrifft ein elektronisches System mit einer Wärmeübertragungsvorrichtung. Die Erfindung betrifft weiterhin ein Fortbewegungsmittel, insbesondere ein Kraftfahrzeug, in dem ein solches elektronisches System genutzt wird.

In heutigen Kraftfahrzeugen ist eine Vielzahl von Sensoren verbaut, die z.B. durch Sicherheitsfunktionen, Assistenzfunktionen oder Pilotfunktionen genutzt werden. Beispiele für derartige Sensoren sind Radarsensoren, Lidarsensoren, Ultraschallsensoren oder Kameras.

Bei hohen Umgebungstemperaturen müssen die Sensoren unter Umständen ihre Funktion einstellen oder komplett abschalten, um die interne Elektronik vor einer Überhitzung zu schützen. Hierdurch kann es vorkommen, dass Sicherheitsfunktionen, Assistenzfunktionen oder Pilotfunktionen deaktiviert werden müssen. Um dies zu vermeiden, müssen die Sensoren gekühlt werden bzw. muss die entstehende Wärme durch geeignete Maßnahmen abgeführt werden.

In diesem Zusammenhang beschreibt DE 10 2017 216 241 A1 eine Lidar-Anordnung mit einer Lasereinheit, einer Empfangseinheit und einer Kühlvorrichtung zum Erzeugen einer Kühlluftströmung. Die Lasereinheit, die Empfangseinheit und die Kühlvorrichtung sind um eine Rotationsachse rotierend angeordnet, sodass die Kühlluftströmung zur Kühlung der rotierenden Komponenten durch die Lidar-Anordnung selbst erzeugt wird.

Oftmals sind elektronische Komponenten innerhalb eines Steuergerätes oder allgemeiner innerhalb eines Gehäuses angeordnet. Zudem können diese elektronischen Komponenten beweglich ausgeführt sein, z.B. um Verbautoleranzen ausgleichen zu können. Beispielsweise können in einem Lidarsensor zwei Lidarköpfe beweglich in einem Sensorgehäuse angeordnet sein. Unter diesen Umständen kann es vorkommen, dass die elektronischen Komponenten nicht hinreichend gekühlt werden können.

Vor diesem Hintergrund beschreibt DE 195 20 938 A1 eine Anordnung zur thermischen Kopplung zwischen einem Bauelement und einem Kühlkörper, bei denen die Ebenen der thermisch kontaktierbaren Oberflächen von der Parallelität und einem Nennabstand abweichen. Es sind zwei komplementäre, spielbehaftet mäanderförmig ineinandergreifende Wärmeübertragungsglieder vorgesehen. Eines der Wärmeübertragungsglieder ist an dem Kühlkörper starr befestigt. Das andere Wärmeübertragungsglied ist federbelastet flächenhaft mit einer thermisch kontaktierbaren Oberfläche des Bauelements verbunden.

DE 10 2018 202 303 A1 beschreibt ein Sensorsystem zum Anbringen einer Sensoranordnung an einem Fahrzeug. Das System umfasst die Sensoranordnung mit einem Gehäuse und einem Sensor, eine fahrzeugseitig montierbare Verbindungsanordnung, an der die Sensoranordnung befestigt ist, und zumindest eine Heatpipe, die die Sensoranordnung und die Verbindungsanordnung wärmeleitend verbindet. Die Sensoranordnung ist gegenüber der Verbindungsanordnung um zumindest einen Freiheitsgrad verstellbar.

US 5,787,976 beschreibt einen Wärmekoppler zur thermischen Kopplung zwischen einer Wärmequelle und einer Wärmesenke. Der Wärmekoppler umfasst ein erstes und ein zweites Substrat. Das erste Substrat weist eine erste Oberfläche auf. Eine Vielzahl von ersten Kanälen wird auf die erste Oberfläche geätzt, um eine Vielzahl von ersten Rippen und eine erste Basis zu bilden. Die erste Basis kann thermisch mit der Wärmequelle in Kontakt gebracht werden. Das zweite Substrat weist eine zweite Oberfläche mit mehreren darin geätzten zweiten Kanälen auf. Die zweiten Kanäle bilden mehrere zweite Rippen und eine zweite Basis. Die zweite Basis kann thermisch mit der Wärmesenke in Kontakt gebracht werden. Die ersten und zweiten Rippen stellen einen wärmeleitenden Pfad von der Wärmequelle zur Wärmesenke bereit, wenn sie miteinander verschachtelt sind.

Bei aktuell verfügbaren Lidarsensoren werden Wärmekoppler mit ineinandergreifenden Rippen verwendet, um Wärme vom Lidarkopf zum Gehäuse abzuführen. Die Wärmeübertragung erfolgt dabei mittels Wärmestrahlung. Der Lidarkopf lässt sich so allerdings nur in einer Achse verdrehen. Dies hat den Nachteil, dass eine externe Justagevorrichtung notwendig ist. Eine Bewegung um zwei Achsen ist mit diesem Konzept nur möglich, wenn mehrere miteinander gekoppelte Wärmekoppler verwendet werden. Dies ist allerdings mit hohen Kosten verbunden und erfordert einen relativ großen Bauraum.

US 2005/0168941 A1 beschreibt ein System zum Abführen von Wärme aus einer eingehausten elektronischen Vorrichtung. Das System umfasst eine Wärmesenke, Leitungswege mit flexiblen thermischen Verbindern, die wärmeerzeugende Elemente thermisch mit der Wärmesenke koppeln, so dass die Wärmesenke von den wärmeerzeugenden Elementen erzeugte Wärme aufnimmt, und ein Wärmeableitungselement, das thermisch mit der Wärmesenke gekoppelt und so konfiguriert ist, dass es Wärme von der Wärmesenke an eine Umgebung außerhalb der Vorrichtung überträgt. Bei den flexiblen thermischen Verbindern kann es sich um wärmeleitende Fasern handeln, die in eine Wärmeleitpaste eingebettet sein Können.

Es ist eine Aufgabe der Erfindung, eine verbesserte Lösung zur Wärmeübertragung in einem elektronischen System bereitzustellen.

Diese Aufgabe wird durch ein System mit den Merkmalen des Anspruchs 1 gelöst. Bevorzugte Ausgestaltungen der Erfindung sind Gegenstand der abhängigen Ansprüche.

Gemäß einem Aspekt der Erfindung umfasst ein elektronisches System:
- ein Gehäuse;
- eine in dem Gehäuse angeordnete elektronische Komponente; und
- eine Wärmeübertragungsvorrichtung zum Transportieren von Wärme von der elektronischen Komponente zum Gehäuse, wobei die Wärmeübertragungsvorrichtung zumindest ein flexibel ausgestaltetes röhrenförmiges Element aufweist, das an einem ersten Ende mit der elektronischen Komponente verbunden ist und das an einem zweiten Ende mit dem Gehäuse verbunden ist und mit einem wärmeleitenden Medium gefüllt ist, wobei das wärmeleitende Medium eine Flüssigkeit ist und in einem direkten Kontakt mit dem Gehäuse steht.

Die erfindungsgemäße Lösung erlaubt eine effektive Kühlung der in dem Gehäuse befindlichen elektronischen Komponente. Das elektronische System kann so auch bei höheren Temperaturen weiterhin mit voller Leistungsfähigkeit arbeiten. Durch die Nutzung einer flexiblen Anbindung der elektronischen Komponente an das Gehäuse für die Wärmeübertragung kann die elektronische Komponente in einem gewissen Umfang justiert werden, ohne dass es zu Einschränkungen bei der Kühlung kommt.

Erfindungsgemäß ist das flexibel ausgestaltete röhrenförmige Element mit einem wärmeleitenden Medium gefüllt. Bei dem wärmeleitenden Medium handelt es sich um eine Flüssigkeit. Durch die Verwendung eines wärmeleitenden Materials als Füllung wird die Wärmeleitung erheblich gesteigert. Werden Flüssigkeiten als Füllung genutzt, kann das röhrenförmige Element als Wärmerohr bzw. Heatpipe ausgestaltet sein.

Erfindungsgemäß steht das wärmeleitende Medium in einem direkten Kontakt mit dem Gehäuse. Zudem kann es in einem direkten Kontakt mit der elektronischen Komponente stehen. Dies sorgt für einen guten Wärmeübertrag in das wärmeleitende Medium, ohne dass zusätzliche Maßnahmen für die Beseitigung von Hohlräumen, z.B. Riefen oder Rillen, am Gehäuse oder der elektronischen Komponente erforderlich sind. Derartige Hohlräume müssten andernfalls durch das Aufbringen einer Wärmeleitpaste ausgeglichen werden. Zur Erhöhung des Wärmeübertrags kann am Gehäuse oder an der elektronischen Komponente eine zusätzliche Platte aus einem wärmeleitenden Material vorgesehen sein, z.B. eine Kupferplatte.

Gemäß einem Aspekt der Erfindung ist die elektronische Komponente um zumindest eine Achse drehbar oder entlang zumindest einer Achse verschiebbar. Natürlich können für die Justage der elektronischen Komponente auch mehrere Freiheitsgrade vorgesehen sein. Bei der Justage wird die elektronische Komponente nur sehr langsam und in der Regel auch nur in einem kleinen Bereich bewegt. Beispielsweise wird der Sensorkopf eines Lidarsensors bei der Justage nur um wenige Grad innerhalb von mehreren Minuten verdreht, typischerweise um 1°-2°. Derartige Verdrehungen können durch die erfindungsgemäße Lösung gut ausgeglichen werden. Da keine starre Verbindung zwischen der elektronischen Komponente und dem Gehäuse besteht, treten keine Probleme durch Materialermüdung auf.

Gemäß einem Aspekt der Erfindung ist das flexibel ausgestaltete röhrenförmige Element ein elastischer Schlauch. Beispielsweise kann es sich bei dem elastischen Schlauch um einen Silikon-Schlauch handeln. Silikon zeichnet sich durch eine gute thermische Leitfähigkeit aus, sodass Wärme zuverlässig abgeführt werden kann.

Gemäß einem Aspekt der Erfindung ist das wärmeleitende Medium Wasser, Ammoniak oder Methanol. Bei diesen Flüssigkeiten handelt es sich um Substanzen, die oftmals für Wärmerohre genutzt werden, sodass umfangreiche Erfahrungswerte vorliegen. Die Verwendung von Methanol hat dabei den Vorteil, dass es für Anwendungen im Frostbereich geeignet ist.

Gemäß einem Aspekt der Erfindung ist die elektronische Komponente ein Sensorkopf. Bei Sensorköpfen ist regelmäßig eine Justage erforderlich, nachdem der Sensor verbaut wurde. Die Verwendung der erfindungsgemäßen Lösung erlaubt eine Justage mit mehreren Freiheitsgraden, ohne dass es zu Einschränkungen bei der Wärmeübertragung kommt.

Besonders vorteilhaft wird ein erfindungsgemäßes elektronisches System in einem Fortbewegungsmittel verwendet, beispielsweise in Form eines Lidarsensors oder eines Radarsensors. Bei dem Fortbewegungsmittel kann es sich insbesondere um ein Kraftfahrzeug handeln, z.B. um einen Personenkraftwagen, ein Nutzfahrzeug oder einen Bus. Die Nutzung der erfindungsgemäßen Lösung erlaubt es dabei, Verbautoleranzen oder Lageänderungen des Fortbewegungsmittels aufgrund eines Beladungszustandes auszugleichen.

Weitere Merkmale der vorliegenden Erfindung werden aus der nachfolgenden Beschreibung und den angehängten Ansprüchen in Verbindung mit den Figuren ersichtlich.
- Fig. 1: zeigt schematisch ein elektronisches System mit einer Wärmeübertragungsvorrichtung gemäß dem Stand der Technik;
- Fig. 2: zeigt schematisch eine Ausführungsform eines elektronischen Systems mit einem flexibel ausgestalteten röhrenförmigen Element;
- Fig. 3: zeigt das elektronische System aus Fig. 2 nach einer Verdrehung einer elektronischen Komponente;
- Fig. 4: zeigt das elektronische System aus Fig. 2 nach einer Verschiebung einer elektronischen Komponente;
- Fig. 5: zeigt schematisch eine Ausführungsform eines elektronischen Systems mit zwei flexibel ausgestalteten röhrenförmigen Elementen; und
- Fig. 6: stellt schematisch ein Fortbewegungsmittel dar, in dem ein erfindungsgemäßes elektronisches System verwendet wird.

Zum besseren Verständnis der Prinzipien der vorliegenden Erfindung werden nachfolgend Ausführungsformen der Erfindung anhand der Figuren detaillierter erläutert. Es versteht sich, dass sich die Erfindung nicht auf diese Ausführungsformen beschränkt und dass die beschriebenen Merkmale auch kombiniert oder modifiziert werden können, ohne den Schutzbereich der Erfindung zu verlassen, wie er in den angehängten Ansprüchen definiert ist.

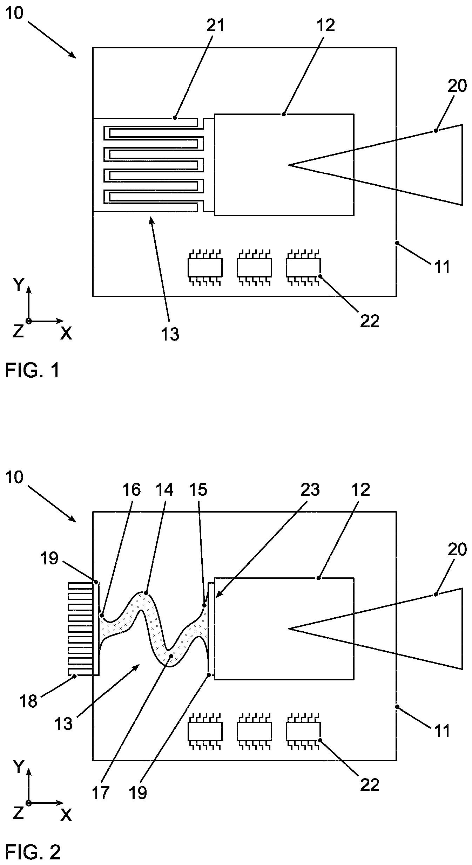

Fig. 1 zeigt schematisch eine Draufsicht auf ein elektronisches System 10 mit einer Wärmeübertragungsvorrichtung 13 gemäß dem Stand der Technik. Das elektronische System 10 umfasst ein Gehäuse 11 sowie eine in dem Gehäuse 11 angeordnete elektronische Komponente 12. Im dargestellten Beispiel handelt es sich bei der elektronischen Komponente 12 um den Sensorkopf eines Lidarsensors. Der Sensorkopf hat einen Erfassungskegel 20. In dem Gehäuse 11 befindet sich eine interne Elektronik 22, die vor erhöhten Temperaturen geschützt werden soll. Zum Transportieren von Wärme von der elektronischen Komponente 12 zum Gehäuse 11 ist eine Wärmeübertragungsvorrichtung 13 vorgesehen. Diese umfasst eine Reihe von ineinandergreifenden Rippen 21, die keine direkte Verbindung haben und zwischen denen ein Wärmeübertrag mittels Wärmestrahlung erfolgt. Nach dem Verbau des elektronischen Systems 10 ist unter Umständen eine Justage der elektronischen Komponente 12 erforderlich. Beispielsweise muss nach dem Verbau eines Lidarsensors in einem Kraftfahrzeug der Sensorkopf ausgerichtet werden, damit der Erfassungskegel 20 einen gewünschten Bereich abdeckt. Bei einer Änderung der Beladung des Kraftfahrzeugs kann eine erneute Ausrichtung des Sensorkopfes erforderlich werden. Bei dem in Fig. 1 gezeigten System 10 ist eine Drehung um die Y-Achse sowie eine Verschiebung entlang der X-Achse sowie der Z-Achse möglich. Insbesondere Drehungen um die X-Achse und die Z-Achse können nicht vorgenommen werden.

Fig. 2 zeigt schematisch eine Ausführungsform eines elektronischen Systems 10 mit einer Wärmeübertragungsvorrichtung 13 mit einem flexibel ausgestalteten röhrenförmigen Element 14. Das röhrenförmige Element 14 weist in dieser Ausführungsform eine flexible Hülle auf, in der sich ein wärmeleitendes Medium 17 befindet. Beispielsweise kann das röhrenförmige Element 14 als elastischer Schlauch ausgestaltet sein, z.B. als Silikon-Schlauch. Bei dem wärmeleitenden Medium 17 handelt es sich um eine Flüssigkeit, z.B. um Wasser, Ammoniak oder Methanol. Mit einem ersten Ende 15 ist das röhrenförmige Element 14 über eine optionale Kupferplatte 19 thermisch an die elektronische Komponente 12 angebunden. Natürlich können auch andere wärmeleitende Materialien für die thermische Anbindung genutzt werden. Ebenso kann das wärmeleitende Medium 17 auch in einem direkten Kontakt mit dem Gehäuse 11 oder der elektronischen Komponente 12 stehen. Bei der elektronischen Komponente 12 handelt es sich wiederum um den Sensorkopf eines Lidarsensors. Das zweite Ende 16 des röhrenförmigen Elements 14 ist thermisch an eine Wärmesenke 18 am Gehäuse 11 angebunden. In Fig. 2 ist die Wärmesenke 18 in Form von Kühlrippen dargestellt. Auch an der Wärmesenke 18 kann die Wärmeanbindung über eine optionale Kupferplatte 19 erfolgen. Die Verwendung eines flexiblen röhrenförmigen Elements 14 erlaubt Drehungen der elektronischen Komponente 12 um alle drei Achsen und Verschiebungen der elektronischen Komponente 12 entlang aller drei Achsen, solange ein maximaler Bewegungsspielraum des röhrenförmigen Elements 14 nicht überschritten wird. Zur Erhöhung des Wärmeübertrags kann die Oberfläche einer Innenwand 23 des Sensorkopfes aufgeraut sein. Durch das Aufrauen der Oberfläche wird die effektive Oberfläche der Innenwand 23 vergrößert. Zudem kann die Innenwand 23 zur Steigerung des Wärmeübertrages mit einer Infrarot-absorbierenden Beschichtung versehen sein. Beispielsweise kann die Innenwand 23 mit einer Infrarot-absorbierende Farbe versehen werden, z.B. mit einer Rußbeschichtung.

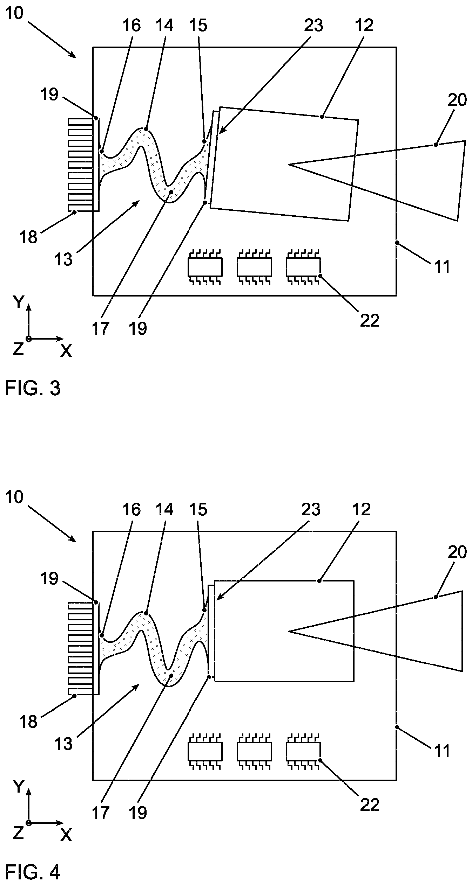

Fig. 3 zeigt das elektronische System 10 aus Fig. 2 nach einer Verdrehung des Sensorkopfes um die Z-Achse. Die dargestellte Verdrehung ist dabei größer, als dies im Regelbetrieb zu erwarten ist. Durch die Verdrehung hat sich die Form des röhrenförmigen Elements 14 geringfügig verändert, ohne dass dadurch die Wärmeübertragung zur Wärmesenke 18 verändert wurde. Es wird daher unverändert eine effiziente Kühlung des Sensorkopfes erreicht.

Fig. 4 zeigt das elektronische System 10 aus Fig. 2 nach einer Verschiebung des Sensorkopfes entlang der Y-Achse. Die dargestellte Verschiebung ist dabei größer, als dies im Regelbetrieb zu erwarten ist. Wie schon in Fig. 3 hat sich die Form des röhrenförmigen Elements 14 geringfügig verändert, ohne dass dies zu einer Änderung der Wärmeübertragung zur Wärmesenke 18 führt. Es wird daher unverändert eine effiziente Kühlung des Sensorkopfes erreicht.

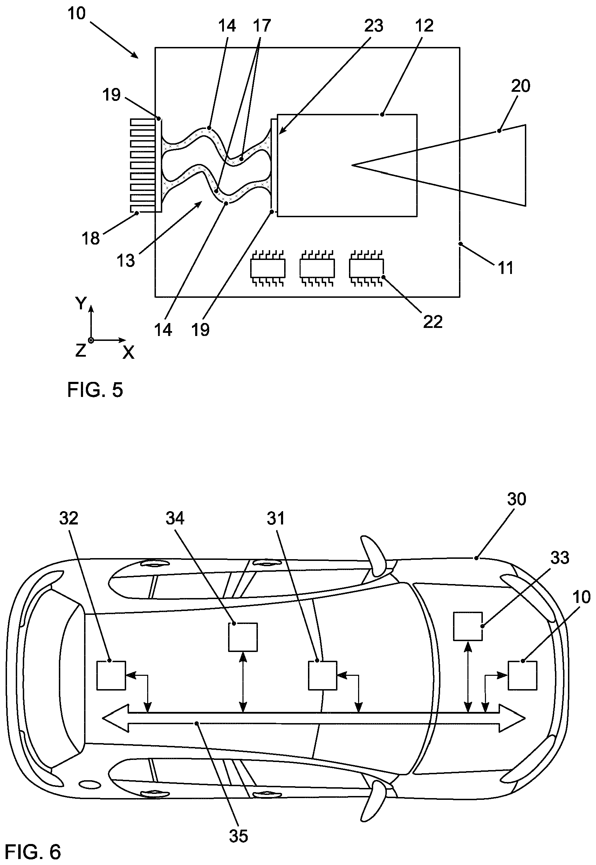

Fig. 5 zeigt schematisch eine Ausführungsform eines elektronischen Systems 10 mit zwei flexibel ausgestalteten röhrenförmigen Elementen 14. Das System 10 ist weitgehend identisch mit dem in Fig. 2 dargestellten System 10, allerdings ist die elektronische Komponente 12 in diesem Fall mit zwei flexibel ausgestalteten röhrenförmigen Elementen 14 thermisch an das Gehäuse 11 angebunden. Natürlich können auch mehr als zwei röhrenförmige Elemente 14 verwendet werden. Darüber hinaus können diese auch an unterschiedliche Wärmesenken 18 gekoppelt sein, insbesondere auch an unterschiedlichen Seiten des Gehäuses 11. Ebenso können die röhrenförmigen Elemente 14 auch an unterschiedliche Seiten elektronischen Komponente 12 gekoppelt sein. Zudem besteht die Möglichkeit, die verschiedenen röhrenförmigen Elemente 14 unterschiedlich auszugestalten, z.B. hinsichtlich des verwendeten wärmeleitenden Materials 17.

Fig. 6 stellt schematisch ein Fortbewegungsmittel 30 dar, in dem ein erfindungsgemäßes elektronisches System 10 verwendet wird. In diesem Beispiel handelt es sich beim Fortbewegungsmittel 30 um ein Kraftfahrzeug und bei dem elektronischen System 10 um einen Lidarsensor. Neben dem Lidarsensor kann das Kraftfahrzeug auch weitere Umgebungssensorik 31 aufweisen, z.B. Kameras oder Ultraschallsensoren. Weitere Komponenten des Kraftfahrzeugs sind eine Datenübertragungseinheit 32 sowie eine Reihe von Assistenzsystemen 33, von denen eines exemplarisch dargestellt ist. Mittels der Datenübertragungseinheit 32 kann beispielsweise eine Verbindung zu Dienstanbietern aufgebaut werden. Zur Speicherung von Daten ist ein Speicher 34 vorhanden. Der Datenaustausch zwischen den verschiedenen Komponenten des Kraftfahrzeugs erfolgt über ein Netzwerk 35.

### Bezugszeichenliste

- 10: Elektronisches System
- 11: Gehäuse
- 12: Elektronische Komponente
- 13: Wärmeübertragungsvorrichtung
- 14: Flexibles röhrenförmiges Element
- 15: Erstes Ende
- 16: Zweites Ende
- 17: Wärmeleitendes Medium
- 18: Wärmesenke
- 19: Kupferplatte
- 20: Erfassungskegel
- 21: Rippe
- 22: Interne Elektronik
- 23: Innenwand
- 30: Fortbewegungsmittel
- 31: Umgebungssensorik
- 32: Datenübertragungseinheit
- 33: Assistenzsystem
- 34: Speicher
- 35: Netzwerk

## Patentansprüche

1. Elektronisches System (10) mit:
- einem Gehäuse (11);
- einer in dem Gehäuse (11) angeordneten elektronischen Komponente (12); und
- einer Wärmeübertragungsvorrichtung (13) zum Transportieren von Wärme von der elektronischen Komponente (12) zum Gehäuse (11), wobei die Wärmeübertragungsvorrichtung (13) zumindest ein flexibel ausgestaltetes röhrenförmiges Element (14) aufweist, das an einem ersten Ende (15) mit der elektronischen Komponente (12) verbunden ist und das an einem zweiten Ende (16) mit dem Gehäuse (11) verbunden ist und mit einem wärmeleitenden Medium (17) gefüllt ist, wobei das wärmeleitende Medium (17) in einem direkten Kontakt mit dem Gehäuse (11) steht, **dadurch gekennzeichnet, dass** das wärmeleitende Medium (17) eine Flüssigkeit ist.

2. Elektronisches System (10) gemäß Anspruch 1, wobei die elektronische Komponente (12) in dem Gehäuse (11) um zumindest eine Achse drehbar oder entlang zumindest einer Achse verschiebbar ist.

3. Elektronisches System (10) gemäß Anspruch 1 oder 2, wobei das flexibel ausgestaltete röhrenförmige Element (14) ein elastischer Schlauch ist.

4. Elektronisches System (10) gemäß einem der vorherigen Ansprüche, wobei das wärmeleitende Medium (17) Wasser, Ammoniak oder Methanol ist.

5. Elektronisches System (10) gemäß einem der vorherigen Ansprüche, wobei das wärmeleitende Medium (17) in einem direkten Kontakt mit der elektronischen Komponente (12) steht.

6. Elektronisches System (10) gemäß einem der vorherigen Ansprüche, wobei die elektronische Komponente (12) ein Sensorkopf ist.

7. Elektronisches System (10) gemäß Anspruch 6, wobei eine Oberfläche einer Innenwand (23) des Sensorkopfes aufgeraut ist.

8. Fortbewegungsmittel (30), **dadurch gekennzeichnet, dass** das Fortbewegungsmittel (30) ein elektronisches System (10) gemäß einem der Ansprüche 1 bis 7 aufweist.

## Claims

1. Electronic system (10) comprising:
- a housing (11);
- an electronic component (12) arranged in the housing (11); and
- a heat transfer device (13) for transporting heat from the electronic component (12) to the housing (11), the heat transfer device (13) having at least one flexible tubular element (14) which is connected at a first end (15) to the electronic component (12) and connected at a second end (16) to the housing (11), and which is filled with a heat-conducting medium (17),the heat-conducting medium (17) being in direct contact with the housing (11), **characterized in that** the heat-conducting medium (17) is a liquid.

2. Electronic system (10) according to claim 1, wherein the electronic component (12) is rotatable about at least one axis or movable along at least one axis in the housing (11).

3. Electronic system (10) according to claim 1 or 2, wherein the flexible tubular element (14) is an elastic hose.

4. Electronic system (10) according to any of the preceding claims, wherein the heat-conducting medium (17) is water, ammonia or methanol.

5. Electronic system (10) according to any of the preceding claims, wherein the heat-conducting medium (17) is in direct contact with the electronic component (12).

6. Electronic system (10) according to any of the preceding claims, wherein the electronic component (12) is a sensor head.

7. Electronic system (10) according to claim 6, wherein a surface of an inner wall (23) of the sensor head is roughened.

8. Transportation means (30), **characterized in that** the transportation means (30) comprises an electronic system (10) according to any of claims 1 to 7.

## Revendications

1. Système électronique (10) comportant :
- un boîtier (11) ;
- un composant électronique (12) disposé dans le boîtier (11) ; et
- un dispositif de transfert de chaleur (13) pour le transport de la chaleur du composant électronique (12) au boîtier (11), dans lequel le dispositif de transfert de chaleur (13) présente au moins un élément tubulaire de conception flexible (14) qui est relié, au niveau d'une première extrémité (15), au composant électronique (12) et qui est relié, au niveau d'une seconde extrémité (16), au boîtier (11) et qui est rempli d'un milieu conducteur de chaleur (17), dans lequel le milieu conducteur de chaleur (17) est en contact direct avec le boîtier (11), **caractérisé en ce que** le milieu conducteur de chaleur (17) est un liquide.

2. Système électronique (10) selon la revendication 1, dans lequel le composant électronique (12) peut tourner autour d'au moins un axe ou coulisser le long d'au moins un axe dans le boîtier (11).

3. Système électronique (10) selon la revendication 1 ou 2, dans lequel l'élément tubulaire de conception flexible (14) est un tube élastique.

4. Système électronique (10) selon l'une des revendications précédentes, dans lequel le milieu conducteur de chaleur (17) est de l'eau, de l'ammoniac ou du méthanol.

5. Système électronique (10) selon l'une des revendications précédentes, dans lequel le milieu conducteur de chaleur (17) est en contact direct avec le composant électronique (12).

6. Système électronique (10) selon l'une des revendications précédentes, dans lequel le composant électronique (12) est une tête de capteur.

7. Système électronique (10) selon la revendication 6, dans lequel une surface d'une paroi intérieure (23) de la tête de capteur est rendue rugueuse.

8. Moyen de locomotion (30), **caractérisé en ce que** le moyen de locomotion (30) présente un système électronique (10) selon l'une des revendications 1 à 7.
